# EUROPEAN PATENT SPECIFICATION

(11) **EP 4 427 004 B1**
(45) Date of publication and mention of the grant of the patent: **01.07.2026**
(21) Application number: 22800002.2
(22) Date of filing: 25.10.2022
(51) Int. Cl.: G01H 1/04, G01H 1/12, G01R 31/12, H02H 1/00

(54) **A SENSOR DEVICE, A SYSTEM, A METHOD AND A COMPUTER PROGRAM FOR DETECTION OF ELECTRICAL ABNORMALITIES IN ASSOCIATION WITH ELECTRICAL EQUIPMENT**
SENSORVORRICHTUNG, SYSTEM, VERFAHREN UND COMPUTERPROGRAMM ZUR ERKENNUNG VON ELEKTRISCHEN ANOMALIEN IN ZUSAMMENHANG MIT EINER ELEKTRISCHEN AUSRÜSTUNG
DISPOSITIF CAPTEUR, SYSTÈME, PROCÉDÉ ET PROGRAMME INFORMATIQUE POUR LA DÉTECTION D'ANOMALIES ÉLECTRIQUES EN ASSOCIATION AVEC UN ÉQUIPEMENT ÉLECTRIQUE

(30) Priority: 02.11.2021 SE 2151344
(43) Date of publication of application: 11.09.2024
(73) Proprietor: Eliguard AB, 545 21 Töreboda (SE)
(72) Inventor: MAGNUSSON, Fredrik, 132 37 Saltsjö-boo (SE); FRYKHOLM, Gustav, 118 30 Stockholm (SE); BURGEMEISTER, Magnus, 431 44 Mölndal (SE)
(74) Representative: Zacco Sweden AB
(86) International application number: PCT/SE2022/050973
(87) International publication number: WO 2023/080820

(56) References cited:
- CN-B- 108 761 285
- US-A1- 2015 271 936
- US-B2- 9 304 159

## Description

### TECHNICAL FIELD

The present disclosure relates to a sensor device, a system, a method and a computer program for detection of electrical abnormalities in association with electrical equipment. More specifically, the disclosure relates to a sensor device, a system, a method and a computer program for detection of electrical abnormalities in association with electrical equipment as defined in the introductory parts of the independent claims.

### BACKGROUND ART

Electrical abnormalities, such as sparks, electric arcs and increased heat may occur in association with electrical equipment, for example due to various failures or overvoltage. Such abnormalities may lead to a fire and consequently to severe damage of the electrical equipment and its surroundings. In order to detect abnormalities and thereby prevent damages, various types of alert systems and devices exists, including voltage measurements, optical sensors and/or acoustic sensors. Most of these systems and devices are, however, very complex and expensive. Furthermore, many of these systems react to abnormalities too late, when the damage has already occurred or the fire already started.

As an example, US 2020/0144806 A1 discloses a method and device for detecting the formation of an electric arc in an electrical system from its acoustic signature. The system comprises an acoustic sensor, such as an ultrasound sensor, configured to detect acoustic waves in the electrical system. The sensor can be arranged on a wall of a housing of the electrical system, or in physical contact with the electrical conductor that one wishes to monitor.

US 10366596 BB discloses a monitoring system for detecting electrical equipment failure. The system includes an ultrasonic sensor mounted for example on the inside of a door or wall of a cabinet facing the electrical equipment. The ultrasonic sensor can be used to set a threshold sound level representative of ultrasonic emissions radiating from the electrical equipment in good working order. During monitoring, the ultrasonic sensor can detect when an event of arcing, tracking, or corona occurs because the sound level will be above the ambient threshold.

US 2015/271936 discloses a sensor configured to be arranged on an electrical conductor, such as a bus bar. Mounting rails for electrical equipment are commonly known and are typically strips used to mount and secure various electrical components like circuit breakers, terminal blocks, and power supplies inside an electrical cabinet. It provides mechanical support but does not conduct electricity.

While the above-mentioned systems according to prior art addresses some of the problems associated with systems for detecting electrical abnormalities, they often fail to provide an accurate and reliable monitoring and often detect the potential danger too late. There is thus a need for an improved sensor device and system for detection of electrical abnormalities in association with electronic equipment.

### SUMMARY

It is an object of the present disclosure to mitigate, alleviate or eliminate one or more of the deficiencies and disadvantages in the prior art and solve at least one of the current problems. It is a particular object of the present disclosure to provide a sensor device and system for detection of electrical abnormalities, which is easy to install and cost-efficient.

Another object of the present disclosure is to provide a sensor device and system for detection of electrical abnormalities in association of electrical equipment specifically in power stations, electrical cabinets, electrical switchboards and switchgears.

Yet another object of the present disclosure is to provide a sensor device and system for detection of electrical abnormalities, which by accurate and reliable monitoring enables timely alerts and thereby reduces the risk of severe damages.

According to claim 1, there is provided a sensor device for detection of electrical abnormalities in association with electrical equipment. The sensor device comprises a housing; and an acoustic sensor element arranged inside the housing to register acoustic signals reflecting sound of the electrical equipment; wherein the acoustic sensor element is operatively connectable to at least one processor configured to detect the presence of electrical abnormalities based on the acoustic signals registered by the acoustic sensor element, wherein the sensor device is configured to be arranged on a mounting rail for electrical equipment and the sensor device is configured such that, when arranged on the mounting rail, the acoustic sensor element abuts the mounting rail.

The sensor device is thus configured to register acoustic signals reflecting sound from the electrical equipment arranged in association with the mounting rail on which the sensor device is attached. The sound manifests itself in form of structure-borne sound or vibrations in the mounting rail, which vibrations is picked up by the sensor device and converted to electrical signals. The sensor device is also referred to as an acoustic sensor device.

Electrical equipment in electrical cabinets, electrical switchboards and equipment racks are typically mounted on mounting rails. One known standard mounting rail is the so-called DIN rail, which is a metal rail used all over the world. There are three different types of DIN rails, one with a so called "top hat section", one with C section and one with G section. The top hat section, with a hat-shaped cross section will herein also be referred to as having a somewhat U-shaped cross section. The DIN rails thus comes in various shapes and sizes with different depths but they typically comprise upper and lower flanges. The sensor device according to the present disclosure may be configured to be mounted on a DIN rail. More specifically, the sensor device according to the present disclosure may be configured to be mounted on a top hat rail. By configuring the sensor device according to the present disclosure, such that the acoustic sensor element abuts the mounting rail, the sensor element will be able to detect vibrations and structure-borne sound from all electrical equipment mounted on the mounting rail. In an electrical cabinet or equipment rack, several mounting rails are typically attached to a common frame or structure. This way, the different mounting rails are mechanically connected to each other via the frame/structure. The acoustic sensor element as disclosed herein, arranged in physical contact with one mounting rail, will thereby be able to detect vibrations and structure-borne sound from electrical equipment on all mounting rails that are attached to the same frame/structure. Thus, only one sensor device is required to monitor a plurality of electrical components arranged inside an electrical cabinet in a very accurate way. This way, a less complex and more cost-efficient way of detecting electrical abnormalities in electrical equipment can be achieved. Furthermore, by arranging the acoustic sensor element in abutment with the mounting rail, the sensor device will be able to detect even small vibrations propagating in the rail. An accurate and reliable sensor device for detecting electrical abnormalities is thereby achieved.

The at least one processor to which the acoustic sensor element is connectable may be comprised in the sensor device or it may be an external processor. In the event that the at least one processor is comprised in the sensor device, the at least one processor may be arranged inside the housing or external to the housing. The sensor device may comprise a communication unit for communication with, for example, the at least one processor. The sensor device may be configured to be included in a mounting rail module. Such module may comprises a housing accommodating the sensor device. The at least one processor connectable to the acoustic sensor element may be accommodated in the module housing as well. Furthermore, the module housing may accommodate a memory and a communication unit.

Electrical abnormalities are herein defined as deviations from normal operation and may thus cause a potential danger. Electrical abnormalities detected by means of the sensor device may include, but is not limited to, formation of sparks, electrical arcs, corona discharge, tracking and sudden increase in temperature of the electric equipment.

According to some embodiments, the sensor device comprises an attachment arrangement for detachable attachment on the mounting rail. The attachment arrangement is advantageously configured to enable an easy and user-friendly mounting of the sensor device on the mounting rail. The attachment arrangement may comprise an upper connection portion and a lower connection portion. Typically, the attachment arrangement is configured to interact with the flanges of the mounting rail. The upper connection portion of the attachment arrangement may thus be configured to interact with an upper flange of the mounting rail, and the lower connection portion may be configured to interact with a lower flange of the mounting rail.

The upper connection portion of the attachment arrangement may be hook shaped, such that it can be hanged over an upper flange of the mounting rail. The lower connection portion may be hook shaped to engage with the lower flange of the mounting rail. This way, the sensor device will be firmly secured on the mounting rail and is prevented from pivoting in relation to the mounting rail. The attachment arrangement may be configured, such that the sensor device can be slidably arranged on the mounting rail. The sensor device may thus be laterally displaced on the mounting rail in an easy way.

The attachment arrangement may comprise a snap-fit connection. The snap-fit connection may be shaped to easily snap the senor device on the mounting rail. The snap-fit connection is configured to interact with at least one flange of the mounting rail. The snap-fit connection may comprise the upper connection portion and the lower connection portion as mentioned above. The attachment arrangement may be somewhat resilient, such that it allows minor deformation of the upper and lower connection portion in order to attach the sensor device on the mounting rail.

In other embodiments, the attachment arrangement comprises an adjustable clamping element. The adjustable clamping element may comprise the lower connection portion. The upper connection portion may in one example form part of an attachment plate connected to, or integrated with, the housing of the sensor device. The adjustable clamping element may be movably arranged in relation to the upper connection portion. As an example, the clamping element may be connected to the attachment plate by means of detachable fastener(s). Thus, by loosening the attachment of the fastener(s) the clamping element can be moved to adjust the distance between the upper connection portion and the lower connection portion. This way, mounting of the sensor device on the mounting rail is facilitated. In another example, the upper connection portion form part of an attachment plate and the housing of the sensor device is integrated with the movable clamping element. The housing may thus be movably arranged in relation to the upper connection portion. This way, the sensor device can be adapted to different sizes of mounting rails. The distance between the upper connection portion and the lower connection portion may correspond to the width of the mounting rail. As an example, the sensor device may be mounted on the mounting rail by moving the clamping element to increase/maximise the distance between the upper and lower connection portion, hanging the sensor device on an upper flange of the mounting rail by means of the upper connection portion, moving the clamping element, such that the lower connection portion abuts/engages the lower flange of the mounting rail, and securing the clamping element by tightening the fastener(s). To detach the sensor device the fastener(s) is loosened and the clamping element is moved so that the distance between the upper and lower connection portions increases, whereby the upper connection portion can be lifted of the upper flange of the mounting rail.

The attachment arrangement may further comprise a spring element arranged to apply a spring force on the movable clamping element in direction towards the upper connection portion. The spring element may be arranged between the housing of the sensor device and the clamping element. Thus, in order to increase the distance between the upper and lower connection portions, the clamping element is moved in a direction opposite to the spring force, thereby compressing the spring element. When the sensor device is arranged on the mounting rail, the spring element ensures that the clamping element is moved upwards, such that the lower connection portion presses against the lower flange of the mounting rail. The attachment arrangement thereby applies a clamping force on the mounting rail and secures the sensor device on the mounting rail.

The acoustic sensor element may comprise a piezoelectric sensor element. In some embodiments, the acoustic sensor element may be a contact microphone for detecting structure-borne sound or vibrations in the mounting rail. The acoustic signals registered by the acoustic sensor element reflect the sound waves generated by the electrical equipment and propagating from the electrical equipment to the acoustic sensor element, via the mounting rail. The acoustic sensor element may be configured to convert the acoustic signals to electrical signals, which are communicated to the at least one processor. The acoustic sensor element may be connected to the at least one processor by means of an electrical cable.

According to some embodiments, the acoustic sensor element comprises a protrusion adapted to extend through an aperture in the housing to abut the mounting rail. In one example, the acoustic sensor element comprises the protrusion and a piezoelectric sensor element arranged in abutment with each other. The protrusion may be arranged in physical contact with a centre area of the piezoelectric element. When the sensor device is arranged on the mounting rail, the protrusion presses against the mounting rail and can thereby detect sound and vibrations propagating in the mounting rail. The protrusion may be movably arranged inside the housing. The protrusion may be a probe or other device configured to convey vibrations to the piezoelectric sensor element. The probe may be T-shaped, wherein the largest surface of the probe is arranged in contact with the piezoelectric sensor element.

The sensor device is typically configured, such that the acoustic sensor element abuts a flange section of the mounting rail. Thus, the sensor device may be configured such that the protrusion abuts a lower flange of the mounting rail. The housing of the sensor device may comprise an aperture arranged to face the mounting rail when the senor device is arranged on the mounting rail. The aperture is suitably arranged at a predetermined position corresponding to the position of the lower flange of the mounting rail. Mounting rails may have different depths of the U-section of the rail. By configuring the sensor device such that the acoustic sensor element abuts a flange section of the mounting rail, the sensor device can be used on various types/sizes of mounting rails. A flexible and cost-efficient sensor device is thereby achieved.

According to some embodiments, the sensor device further comprises a protective sheet arranged adjacent the acoustic sensor element inside the housing. The protective sheet is arranged to protect the acoustic sensor element from any electrical interference. The protective sheet may comprise a plastic film. In the event that the acoustic sensor element comprises a piezoelectric element, the protective sheet may be arranged in abutment with the piezoelectric element.

According to some embodiments, the sensor device also comprises a dampening element arranged in connection with the acoustic sensor element. The dampening element may be referred to as a weight, and is arranged to reduce vibrations and oscillations in the acoustic sensor element itself. The dampening element may comprise metal. The dampening element may be arranged adjacent the protective sheet. Thus, the protective sheet may be arranged between the acoustic sensor element and the dampening element.

According to some embodiments, the sensor device further comprises a pressure part arranged to apply a pressure on the acoustic sensor element. The pressure part may be biased and will thereby apply a force on the acoustic sensor element, such that the acoustic sensor element is pressed against the mounting rail. In the event that the acoustic sensor element comprises a movably arranged protrusion, the pressure part may apply a force on the acoustic sensor element, such that the protrusion is pressed against the mounting rail. This way, the register capacity and accuracy of the sensor device is improved. The pressure part may comprise a spring element, rubber or similar. The biased pressure part may be arranged in abutment with the dampening element, the protective sheet or the acoustic sensor element.

The sensor device may be configured to be included in a mounting rail module. Such module may comprises a housing accommodating the sensor device, the at least one processor, a memory and a communication unit.

According to another aspect of the present disclosure there is provided a system for detecting electrical abnormalities in association with electrical equipment. The system comprises a sensor device as disclosed herein, and at least one processor operatively connectable to the acoustic sensor element of the sensor device, wherein the processor is configured to detect the occurrence of electrical abnormalities based on the acoustic signals registered by the acoustic sensor element.

The at least one processor may be configured to determine at least one characteristic of the registered acoustic signals and compare the determined characteristic with a predetermined characteristic threshold value. As an example, the characteristic comprises energy content and the at least one processor may be configured to compare the energy content of acoustic signals with a predetermined energy content threshold value, and based on the comparison determine if there is an electrical abnormality. The predetermined energy content threshold value may be determined based on energy content values during normal operation of the electrical equipment. If the energy content of a registered acoustic signal is above the threshold value, it indicates that an electrical abnormality has occurred in association with the electrical equipment. The at least one processor of the system may thus be configured to detect electrical abnormalities by determining whether the energy content of the registered acoustic signals exceeds an energy content threshold value, indicating that that an electrical abnormality has occurred.

The at least one processor may be configured to perform a calibration process in order to determine the threshold value. Thus, according to an aspect of the present disclosure, a system for detection of electric abnormalities in association with electrical equipment is provided, the system comprising a sensor device for registering acoustic signals reflecting sound of the electrical equipment as disclosed herein, and at least one processor operatively coupled to the acoustic sensor element of the sensor device. The at least one processor is in this example configured to receive acoustic signals registered by the sensor device during a calibration process; determine an energy content threshold value for acoustic signals within a frequency band to be monitored during monitoring of the electrical equipment following the calibration process, based on the acoustic signals registered within that frequency band during the calibration process; detect, among the acoustic signals registered by the sensor device during monitoring of the electrical equipment following the calibration process, an acoustic pulse within said frequency band, and classifying the acoustic pulse as an electrical abnormality associated with the electrical equipment when an energy content of the acoustic pulse exceeds the energy content threshold value.

The frequency band should preferably be selected to exclude high-energy content acoustic signals generated by the electrical equipment during normal operation thereof, i.e. to exclude frequencies containing a high level of background noise. Preferably, the frequency band should have a bandwidth of at most 100 Hz, preferably at most 75 Hz, and even more preferably at most 50 Hz. A suitable centre frequency of the frequency band may, in some applications, be approximately 1 kHz or 4,5 kHz. The frequency band may be pre-set or determined by the at least one processor based on the acoustic signals registered by the sensor device during the calibration process.

In some embodiments, the at least one processor is configured to compare energy contents of different frequencies of the acoustic signals registered by the sensor device during the calibration process, and determine the frequency band to be monitored as a frequency band having a relatively low energy content, based on the comparison.

It has been found that electric pulses generated by the above-mentioned types of electrical abnormalities has a very short duration in time. The characteristic of the acoustic signals determined by the at least one processor may therefore comprise a pulse duration time. The at least one processor may be configured to determine a pulse duration time of the acoustic pulse, and classify the acoustic pulse as an electrical abnormality only when the pulse duration time is below a maximum pulse duration threshold value. For example, the at least one processor may be configured to determine the pulse duration time as a period of time during which the energy content of the acoustic pulse exceeds the energy content threshold value, wherein the maximum pulse duration threshold value may be set in the range of 15-50 ms. Preferably, the maximum pulse duration threshold value should be at most 40 ms, even more preferably at most 30 ms, and most preferably at most 20 ms.

It has further been found that electric pulses generated by the above-mentioned types of electrical abnormalities have a very sudden increase and decrease in energy content. The characteristic of the acoustic signals determined by the at least one processor may therefore comprise a rate of increase and/or a rate of decrease of the energy content of the acoustic signals. The processor may thus be configured to classify the acoustic pulse as an electrical abnormality based on a rate of increase and/or a rate of decrease of the energy content of the acoustic pulse.

In some embodiments, the at least one processor is configured to determine a measure indicative of a rate of increase of energy content of the acoustic pulse, and to classify the acoustic pulse as an electrical abnormality only when the measure of the rate of increase exceeds a set threshold value. To this end, the at least one processor may be configured to determine an acoustic energy ramp-up time of the acoustic pulse, and to classify the acoustic pulse as an electrical abnormality only if the acoustic energy ramp-up time is below a maximum acoustic energy ramp-up threshold value. The at least one processor may be configured to determine the acoustic energy ramp-up time as a period of time from a first point in time at which the energy content of the acoustic pulse exceeds the energy content threshold value to a second point in time at which the energy content of the acoustic pulse reaches its maximum value, and to use a maximum acoustic energy ramp-up threshold value in the range of 10-40 ms. Preferably, the maximum acoustic energy ramp-up threshold value should be at most 30 ms, even more preferably at most 20 ms, and most preferably at most 10 ms.

Likewise, in some embodiments, the at least one processor may be configured to determine a measure indicative of a rate of decrease of energy content of the acoustic pulse, and to classify the acoustic pulse as an electrical abnormality only when the measure of the rate of decrease exceeds a set threshold value. To this end, the at least one processor may be configured to determine an acoustic energy ramp-down time of the acoustic pulse, and to classify the acoustic pulse as an electrical abnormality only if the acoustic energy ramp-down time is below a maximum acoustic energy ramp-down threshold value. The at least one processor may be configured to determine the acoustic energy ramp-down time as a period of time from a first point in time at which the energy content of the acoustic pulse reaches its maximum value to a second point in time at which the energy content of the pulse falls below the energy content threshold value, and to use a maximum acoustic energy ramp-down threshold value in the range of 10-40 ms. Preferably, the maximum acoustic energy ramp-down threshold value should be at most 30 ms, even more preferably at most 20 ms, and most preferably at most 10 ms.

The at least one processor may also be configured to generate an alarm signal and/or to automatically switch off the electrical equipment in response to classifying the acoustic pulse as an electrical abnormality. In some embodiments the alarm may be generated locally by the sensor device, e.g. in the form of an audible and/or visual alarm for alerting a local user. Instead or in addition to a local alarm, the at least one processor may be configured to generate an alarm signal that is provided to the user via an electronic device of the user, which electronic device is operatively coupled to the sensor device, e.g. via a network server. In some embodiments, the alarm signal may be provided to the user via a mobile application for detection of electrical abnormalities in association with electrical equipment, configured to be run on a mobile electronic device of the user, such as a mobile phone or a tablet computer.

It is to be understood that all features relating to the sensor device are also applicable on the system as disclosed herein.

According to a yet another aspect of the present disclosure there is provided a method for detecting electrical abnormalities in association with electrical equipment by means of a system as disclosed herein. The method comprises:
i) registering acoustic signals reflecting sound of the electrical equipment by means of the sensor device; and
ii) detecting electrical abnormalities based on the registered acoustic signals.

The step of detecting electrical abnormalities based on the registered acoustic signals may comprise determining a threshold value for some characteristic of the acoustic signals, comparing the characteristic of the registered acoustic signals with the threshold value, and detecting electrical abnormalities based on said comparison. The threshold value typically corresponds to the characteristic of the acoustic signals during normal operation of the electrical equipment. The characteristic may comprise energy content and the threshold value may be an energy content threshold value. The step of detecting electrical abnormalities may thus comprise comparing the energy content of the registered acoustic signals with the energy content threshold value and, based on the comparison, determine if an electrical abnormality is occurring in association with the electrical equipment. If the energy content of a registered acoustic signal exceeds the energy content threshold value, it indicates that an electrical abnormality is occurring.

The method may comprise a calibration step in order to determine the threshold value. Thus, according to an aspect of the present disclosure a method for detection of electric abnormalities in association with electrical equipment is provided, the method comprising the steps of registering, by means of a sensor device as disclosed herein during a calibration process, acoustic signals reflecting sound of the electrical equipment during normal operation thereof; determining an energy content threshold value for acoustic signals within at least one frequency band to be monitored during monitoring of the electrical equipment following the calibration process, based on the acoustic signals registered within the at least one frequency band during the calibration process; detecting, among the acoustic signals registered by the sensor device during monitoring of the electrical equipment following the calibration process, an acoustic pulse within the at least one frequency band, and classifying the acoustic pulse as an electrical abnormality associated with the electrical equipment when an energy content of the acoustic pulse exceeds the energy content threshold value for the at least one frequency band. An acoustic pulse is thus an acoustic signal within the predetermined frequency band.

The frequency band should, as mentioned above, preferably be selected to exclude high-energy content acoustic signals generated by the electrical equipment during normal operation thereof, i.e. to exclude frequencies containing a high level of background noise. In some embodiments, the frequency band is pre-set based on the type of electrical equipment to be monitored and/or based on the electrical surroundings of the electrical equipment to be monitored. In this way, the frequency band can be pre-set in dependence of a known frequency spectrum of acoustic noise normally generated by the type of electrical equipment to be monitored and/or by electrical appliances in the surroundings of the electrical equipment to be monitored.

In some embodiments, the frequency band is determined based on the acoustic signals registered by the sensor device during the calibration process, generated by the electrical equipment during normal operation thereof, which acoustic signals represent background noise generated by the electrical equipment during normal operation thereof.

In some embodiments, the method may comprise the steps of comparing energy contents of different frequencies of the acoustic signals registered during the calibration process, and determining the frequency band to be monitored as a frequency band having a relatively low energy content, based on the comparison. The frequency band should preferably be narrow enough to exclude high-energy content acoustic signals generated by the electrical equipment during normal operation thereof. Preferably, the frequency band should have a bandwidth of at most 100 Hz, preferably at most 75 Hz, and even more preferably at most 50 Hz.

Depending on the background noise generated by the electrical equipment to be monitored and electrical appliances in the surroundings of the electrical equipment to be monitored, a suitable centre frequency of the frequency band may be 1 kHz or 4,5 kHz.

To make the method more robust by preventing other sounds from being mistaken for an electrical abnormality, the method may comprise the steps of determining a pulse duration time of the acoustic pulse and classifying the acoustic pulse as an electrical abnormality only if the pulse duration time is below a maximum pulse duration threshold value. When defined as a period of time during which the energy content of the acoustic pulse exceeds the energy content threshold value, the maximum pulse duration threshold value may, e.g., be set to a value in the range of 15-50 ms. Preferably, the maximum pulse duration threshold value should be at most 40 ms, even more preferably at most 30 ms, and most preferably at most 20 ms. To make the method even more robust, classification of the pulse as an electrical abnormality may be performed based on a rate of increase and/or a rate of decrease of the energy content of the acoustic pulse.

In some embodiments, the method may comprise the steps of determining a measure indicative of a rate of increase of energy content of the acoustic pulse, and classifying the acoustic pulse as an electrical abnormality only when the measure of the rate of increase exceeds a set threshold value. This may be achieved, e.g., by determining an acoustic energy ramp-up time of the acoustic pulse, and classifying the acoustic pulse as an electrical abnormality only if the acoustic energy ramp-up time is below a maximum acoustic energy ramp-up threshold value. When defined as a period of time from a first point in time at which the energy content of the acoustic pulse exceeds the energy content threshold value to a second point in time at which the energy content of the acoustic pulse reaches its maximum value, the maximum acoustic energy ramp-up threshold value may, for example, be set to a value in the range of 10-40 ms. Preferably, the maximum acoustic energy ramp-up threshold value should be at most 30 ms, even more preferably at most 20 ms, and most preferably at most 10 ms.

Likewise, in some embodiments, the method may comprise the steps of determining a measure indicative of a rate of decrease of energy content of the acoustic pulse, and classifying the acoustic pulse as an electrical abnormality only when the measure of the rate of decrease exceeds a set threshold value. This may be achieved, e.g., by determining an acoustic energy ramp-down time of the acoustic pulse, and classifying the acoustic pulse as an electrical abnormality only if the acoustic energy ramp-down time is below a maximum acoustic energy ramp-down threshold value. When defined as a period of time from a first point in time at which the energy content of the acoustic pulse reaches its maximum value to a second point in time at which the energy content of the pulse falls below the energy content threshold value, the maximum acoustic energy ramp-down threshold value may, for example, be set to a value in the range of 10-40 ms. Preferably, the maximum acoustic energy ramp-down threshold value should be at most 30 ms, even more preferably at most 20 ms, and most preferably at most 10 ms.

The method may further comprise the step of generating an alarm signal and/or automatically switching off the electrical equipment in response to classifying the occurrence of the acoustic pulse as an electrical abnormality. In this way, a user may be notified about the occurrence of electrical abnormalities in the electrical equipment, and/or the electrical equipment may be switched off upon detection of electrical abnormalities, thereby preventing or at least mitigating the risk of severe damages to the electrical equipment and the surroundings of the electrical equipment.

The above-described method is typically a computer-implemented method that may be performed upon execution of a computer program by one or more processors of a system for detection of electrical abnormalities in association with electrical equipment.

Thus, according to a another aspect of the present disclosure there is provided a computer program comprising computer-readable instructions which, when executed by at least one processor of a system for detecting electrical abnormalities in association with electrical equipment as disclosed herein, causes the at least one processor to perform the steps of:
- receiving acoustic signals reflecting sound of the electrical equipment registered by a sensor device of the system; and
- detecting electrical abnormalities based on the received acoustic signals.

In some embodiments, there is provided a computer program comprising computer-readable instructions which, when executed by at least one processor of a system for detection of electrical abnormalities in association with electrical equipment, causes the at least one processor to perform the steps of: receiving acoustic signals reflecting sound of the electrical equipment during normal operation thereof, registered during a calibration process by a sensor device that is operatively coupled to the at least one processor; determining an energy content threshold value for acoustic signals within a frequency band to be monitored during monitoring of the electrical equipment following the calibration process, based on the acoustic signals registered within that frequency band during the calibration process; detecting, among the acoustic signals registered by the sensor device during monitoring of the electrical equipment following the calibration process, an acoustic pulse within said frequency band, and classifying the acoustic pulse as an electrical abnormality associated with the electrical equipment when an energy content of the acoustic pulse exceeds the energy content threshold value.

The computer program may further comprise instructions for causing the at least one processor of the system to perform any of, or any combination of, the method steps of the above described method.

The computer program may reside entirely in the sensor device or it may be a distributed computer program partly residing in the sensor device and partly residing in a network server to which the acoustic sensor device is communicatively connectable. The computer program may comprise several computer program components configured to perform different steps of the above-described method. For instance, the computer program may comprise a first program component or application for data processing and communication residing in the sensor device, a second program component or application for data analysis and data communication residing in the network server, and a third program component or application in form of a client application for presentation of data and interaction with a user, residing in an electronic device of the user. The client application may, for example, be realized in form of a mobile application (app) configured to be run on a mobile electronic device, such as a mobile phone or a tablet computer.

According to another aspect of the present disclosure there is provided a computer program product comprising at least one computer-readable medium, such as a non-volatile memory, storing the above mentioned computer program.

The present disclosure will become apparent from the detailed description given below. The detailed description and specific examples disclose preferred embodiments of the disclosure by way of illustration only. Those skilled in the art understand from guidance in the detailed description that changes and modifications may be made within the scope of the appended claims.

### BRIEF DESCRIPTIONS OF THE DRAWINGS

The above objects, as well as additional objects, features and advantages of the present disclosure will be more fully appreciated by reference to the following illustrative and nonlimiting detailed description of example embodiments of the present disclosure, when taken in conjunction with the accompanying drawings, of which:
Figure 1A-B illustrate an exemplary embodiment of a sensor device attached to a mounting rail according to the present disclosure;
Figures 2A-C illustrate exemplary embodiments of a sensor device attached to a mounting rail according to the present disclosure;
Figure 3 illustrates an exemplary embodiment of a sensor device attached to a mounting rail according to the present disclosure;
Figure 4 illustrate an exemplary embodiment of a system for detecting electrical abnormalities according to the present disclosure;
Figure 5 illustrates an exemplary embodiment of a method for detecting electrical abnormalities according to the present disclosure.

### DETAILED DESCRIPTION

The present disclosure will now be described with reference to the accompanying drawings, in which preferred example embodiments of the disclosure are shown. The disclosure may, however, be embodied in other forms and should not be construed as limited to the herein disclosed embodiments. The disclosed embodiments are provided merely to fully convey the scope of the disclosure to the skilled person.

It is to be understood that the terminology used herein is for purpose of describing particular embodiments only, and is not intended to be limiting. It should be noted that, as used in the specification and the appended claims, the articles "a", "an", "the", and "said" are intended to mean that there are one or more of the elements unless the context explicitly dictates otherwise. Thus, for example, reference to "a unit" or "the unit" may include several devices, and the like. Furthermore, the terms "comprising", "including", "containing" and similar wordings are intended to be open-ended transitional terms that do preclude the possibility of additional elements or steps.

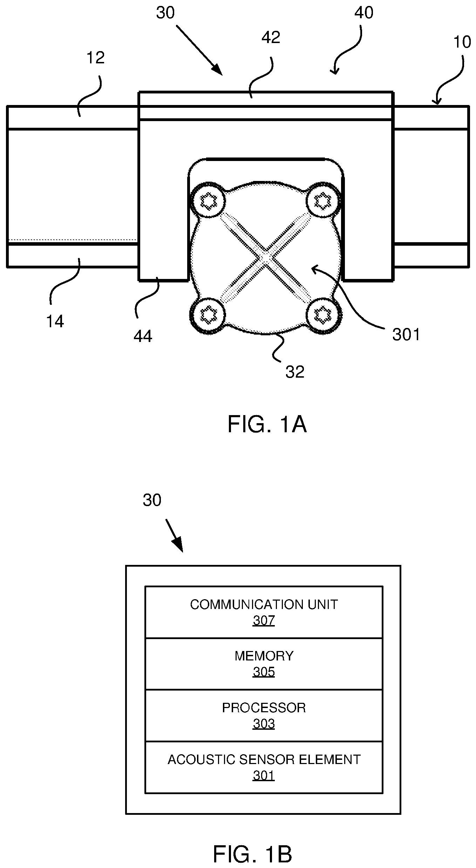

Figure 1A schematically illustrates an exemplary embodiment of the sensor device 30, when attached to the mounting rail 10. The sensor device 30 comprises a housing 32; and an acoustic sensor element 301 arranged inside the housing 32 to register acoustic signals. The acoustic sensor element 301 is operatively connectable to at least one processor 303 configured to detect the presence of electrical abnormalities based on the acoustic signals registered by the acoustic sensor element 301. The at least one processor 303 to which the sensor element 30 is connectable may be comprised in the sensor device 30 or it may be an external processor.

The sensor device 30 comprises an attachment arrangement 40 for detachable attachment on the mounting rail 10. The attachment arrangement 40 may comprise an upper connection portion 42 and a lower connection portion 44. The upper connection portion 42 of the attachment arrangement 40 may thus be configured to interact with an upper flange 12 of the mounting rail 10, and the lower connection portion 44 may be configured to interact with a lower flange 14 of the mounting rail 10. The attachment arrangement 40 may comprise a snap-fit connection. The snap-fit connection may be shaped to easily snap the senor device 30 on the mounting rail 10. The snap-fit connection may comprise the upper connection portion 42 and the lower connection portion 44. The attachment arrangement 40 may be somewhat resilient, such that it allows minor deformation of the upper 42 and lower 44 connection portion in order to attach the sensor device 30 on the mounting rail 10.

Figure 1B illustrates some internal components of an exemplary embodiment of the sensor device 30. In this example, the sensor device 30 comprises an acoustic sensor element 301, at least one processor 303, a memory 305, and a communication unit 307, all of which are arranged inside the housing 32. It is, however, to be understood that the at least one processor 303, the memory 305 and/or the communication unit 307 may be arranged external to the housing 32. The acoustic sensor element 301 is connectable via a wired or wireless connection to the processor 303, the memory 305, and the communication unit 307. In some embodiments (not shown), the sensor device 30 is configured to form part of a standard mounting rail module. Such module may comprise an outer housing accommodating the sensor device 30, the at least one processor 303, the memory 305 and the communication unit 307. The mounting rail module may also be equipped with an attachment arrangement for detachable attachment to the mounting rail 10.

The acoustic sensor element 301 of the sensor device 30 is configured to register acoustic signals reflecting the sound generated by nearby electrical equipment. The sound may manifest itself in form of structure-borne sound or vibrations in the mounting rail 10, which vibrations are picked up by the sensor element 301 and converted by the acoustic sensor element 301 to electrical signals. In some embodiments, the acoustic sensor element 301 may comprise a piezoelectric sensor element. In some embodiments, the acoustic sensor element 301 may be a contact microphone for registering structure-borne sound in the mounting rail 10.

The at least one processor 303 is configured to detect electrical abnormalities associated with the nearby electrical equipment based on the acoustic signals registered by the acoustic sensor element 301 of the sensor device 30. This is achieved by the at least one processor 303 upon execution of a computer program stored in the memory 305. The memory 305 may be integrated with or embedded into the at least one processor 303, or be a separate memory hardware device. The memory may include a random access memory (RAM), a read-only memory (ROM), a hard disk, an optical disk, a magnetic medium, a flash memory or any other mechanism capable of storing instructions or data. The at least one processor 303 may include any physical device having an electric circuit that performs logic operations on input data. For example, the at least one processor 303 may include one or more integrated circuits, microchips, microcontrollers, microprocessors, all or part of a central processing unit (CPU), digital signal processor (DSP), field-programmable gate array (FPGA), or other circuits for executing instructions or performing logic operations. Unless stated otherwise, it should be realized that actions and method steps described hereinafter are performed by the at least one processor 303 upon execution of the computer program stored in the memory 305.

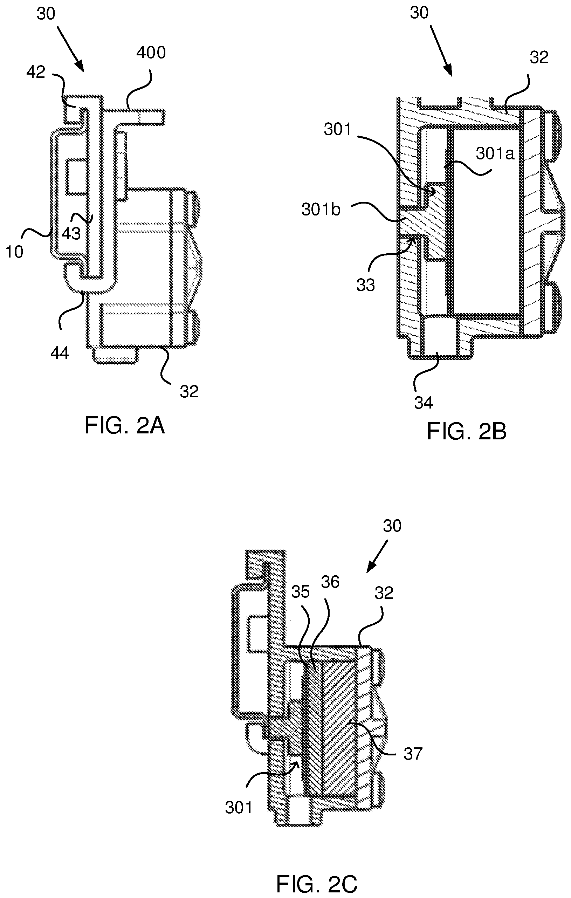

Figure 2A-C schematically illustrate exemplary embodiments of the sensor device 30. The sensor device 30 may be configured as disclosed in figure 1A-B.

Figure 2A discloses an example where the attachment arrangement 40 comprises an adjustable clamping element 400. The adjustable clamping element 400 may comprise the lower connection portion 44 of the attachment arrangement 40. The upper connection portion 42 of the attachment arrangement 40 may be hook shaped, such that it can be hanged over an upper flange 12 of the mounting rail 10. The lower connection portion 44 may also be hook shaped to engage the lower flange 14 of the mounting rail 10.

The upper connection portion 42 may in one example form part of an attachment plate 43 connected to, or integrated with, the housing 32 of the sensor device 30. The adjustable clamping element 400 may be movably arranged in relation to the attachment plate 43. The clamping element 400 can thereby be moved to adjust the distance between the upper connection portion 42 and the lower connection portion 44 of the attachment arrangement 40. This way, mounting of the sensor device 30 on the mounting rail 10 is facilitated. The clamping element 400 may be attached to the attachment plate 43 by means of fasteners, which are loosened in order to allow displacement of the clamping element 400.

Figure 2B schematically illustrates a cross-sectional view of the sensor device 30 according to an example. The figure shows the housing 32 and the acoustic sensor element 301 arranged inside the housing 32. In this example, the acoustic sensor element 301 comprises a piezoelectric sensor element 301a and a protrusion 301b. The protrusion 301b and the piezoelectric sensor element 301a are arranged in abutment with each other. In some embodiments, the acoustic sensor element may be a contact microphone for detecting structure-borne sound in the mounting rail.

The protrusion 301b is adapted to extend through an aperture 33 in the housing 32 to abut the mounting rail 10 during operation of the sensor device 30. When the sensor device 30 is mounted onto the mounting rail 10, the protrusion 301b presses against the mounting rail 10 and can thereby register sound and vibrations propagating in the mounting rail 10. The protrusion 301b may be movably arranged inside the housing 32. The protrusion 301b may be a probe or other device configured to convey vibrations to the piezoelectric sensor element 301a.

The sensor device 30 is typically configured, such that the acoustic sensor element 301 abuts a flange section of the mounting rail 10. The aperture 33 of the housing 32 may thus be arranged to face a flange section of the mounting rail 10 when the senor device 30 is arranged on the mounting rail 10. The aperture 33 is suitably arranged at a predetermined position corresponding to the position of the lower flange 14 of the mounting rail 10.

Figure 2B also shows a connection opening 34 in the housing 32 through which an electrical cable may extend to connect the acoustic sensor element 301 with the at least one processor 303.

Figure 2C schematically illustrate a cross-section view of the sensor device 30 according to an example. In this example, the sensor device 30 further comprises a protective sheet 35 arranged adjacent the acoustic sensor element 301 inside the housing 32. The protective sheet 35 is arranged to protect the acoustic sensor element 301 from any electrical interference. The protective sheet 35 may comprise a plastic film. In the event that the acoustic sensor element 301 comprises a piezoelectric element 301a, the protective sheet 35 may be arranged in abutment with the piezoelectric element 301a.

The sensor device 30 may also comprise a dampening element 36 arranged in connection with the acoustic sensor element 301. The dampening element 36 may be referred to as a weight, and is arranged to reduce vibrations and oscillations in the acoustic sensor element 301 itself. The dampening element 36 may comprise metal. The dampening element 36 is here arranged adjacent the protective sheet 35. Thus, the protective sheet 35 may be arranged between the acoustic sensor element 301 and the dampening element 36.

Furthermore, the sensor device 30 may comprise a pressure part 37 arranged to apply a pressure on the acoustic sensor element 301. The pressure part 37 may be biased and will thereby apply a force on the acoustic sensor element 301, such that the acoustic sensor element 301, 301a, is pressed against the mounting rail 10. The pressure part 37 may comprise a spring element, rubber or similar. The biased pressure part 37 may be arranged in abutment with the dampening element 36, the protective sheet 35 or the acoustic sensor element 301.

It is to be understood that even through this figure shows the protective sheet 35, the dampening element 36 and the pressure part 37 all arranged inside the hosing 32, the sensor device 30 may comprise only one or two of these components.

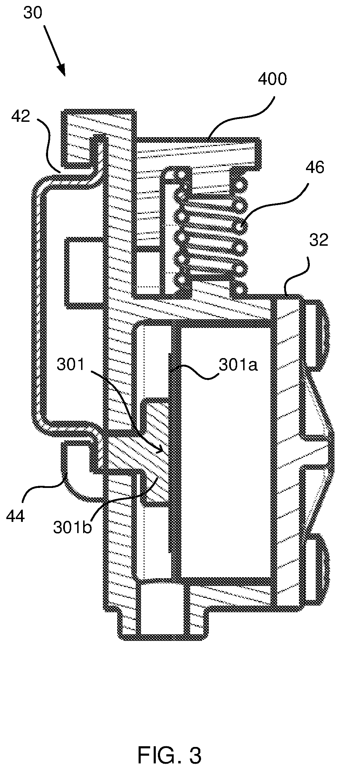

Figure 3 schematically illustrates an exemplary embodiment of a sensor device 30 attached to a mounting rail 10 according to the present disclosure. The sensor device 30 may be configured as disclosed in any of the figures 1A-B or 2A-C.

I this example, the attachment arrangement 40 further comprises a spring element 46 arranged to apply a spring force on the movable clamping element 400 in direction towards the upper connection portion 42. The spring element 46 may be arranged between the housing 32 and the clamping element 400. Thus, in order to increase the distance between the upper and lower connection portions 42, 44, the clamping element 400 is moved in a direction opposite to the spring force, thereby compressing the spring element 46. When the sensor device 30 is arranged on the mounting rail 10, the spring element 46 ensures that the clamping element 400 is moved upwards, such that the lower connection portion 44 presses against the lower flange 14 of the mounting rail 10.

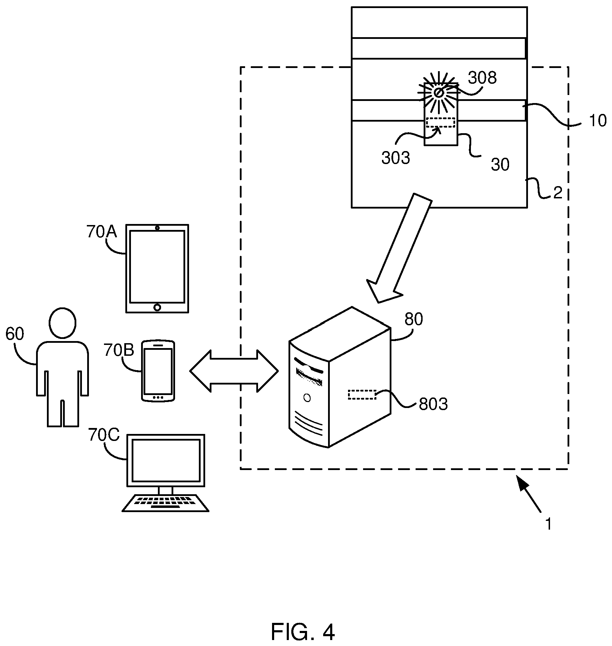

Figure 4 illustrates a system 1 for detecting electrical abnormalities in association with electrical equipment according to an exemplary embodiment of the present disclosure. The system 1 comprises a sensor device 30 for registering acoustic signals reflecting the sound generated by the electrical equipment. The sensor device 30 is here attached to a mounting rail 10, for example in an electrical cabinet 2. The sensor device 30 may be configured as disclosed in any of figures 1a-b, 2a-c and 3. The system 1 further comprises at least one processor 303, 803 that is configured to detect electrical abnormalities based on the acoustic signals registered by the sensor device 30.

The system 1 may further comprise a network server 80 operatively connected to the sensor device 30. The network server 80 may comprise a processor 803.

The system 1 may be configured to generate an alarm signal and/or to automatically switch off the electrical equipment upon detection of electrical abnormalities in association with the electrical equipment. In some embodiments, the system 1 may be configured to generate a local alarm upon detection of electrical abnormalities in association with the electrical equipment. To this end, the sensor device 30 may comprise means 308 for generating an audible and/or visible alarm signal to a local user, such as an audible signal generator and/or a light indicator.

In some embodiments, the system 1 may be configured to alert a remote user 60 upon detection of electrical abnormalities in association with the electrical equipment by causing an alert to be displayed on an electronic device of the user, such as a portable electronic device in form of, e.g., a tablet computer 70A or a mobile phone 70B, or a portable or stationary computer 70C. In the latter scenario, the sensor device 30 may be operatively connected to the network server 80, which, in turn, may be configured to communicate information relating to the detection of electrical abnormalities to the one or more electronic devices 70A-C of the user 60. The network server 80 may, e.g., be a cloud server connected to the Internet, and the communication unit (307 in Fig. 1B) of the sensor device 30 may be configured to communicate with the network server 80 using any known communications protocol.

The functionality for detection of electrical abnormalities in association with the electrical equipment may reside in any or both of the sensor device 30 and the network server 80. When residing in the network server 80, the acoustic signals or characteristics of the acoustic signals registered by the sensor device 30 may be transmitted to the network server 80, whereupon the processor 803 of the network server 80 processes the signals or the characteristics of the signals. Any detection of electrical abnormalities may then be communicated by the network server 80 to the sensor device 30 for generation of a local alarm, and/or to the one or more electronic devices 70A-70C of the user 60 for generation of a remote alarm on the electronic device. When residing in the sensor device 30, the acoustic signals registered by the sensor device 30 may be processed locally by the processor 303 of the sensor device 30, whereupon the sensor device 30 may communicate any detection of electrical abnormalities to the network server 80, in order for the network server 80 to alert the user 60 of the detection of electronic abnormalities via the one or more electronic devices 70A-70C of the user.

The at least one processor 303, 803 of the system 1 may be configured to detect the electrical abnormalities by determining whether a predetermined characteristic of the registered acoustic signals exceeds a characteristic threshold value, indicating that that an electrical abnormality has occurred. More specifically, the at least one processor 303, 803 of the system 1 may be configured to detect the electrical abnormalities by determining whether an energy content of the registered acoustic signals exceeds an energy content threshold value, indicating that that an electrical abnormality has occurred.

Furthermore, the at least one processor 303, 803 may be configured to receive acoustic signals registered by the sensor device 30 during a calibration process, which acoustic signals indicate a background noise generated by the electrical equipment and, perhaps, other electrical and non-electrical objects in the surroundings of the sensor device 30. In some embodiments, the calibration process may last for a predetermined period of time, e.g., an hour or a day. In other embodiments, the calibration process may last until acoustic signals having an energy content exceeding the energy content of previously registered acoustic signals have not been registered for a certain period of time.

The acoustic signals registered by the sensor device 30 during the calibration process is used by the at least one processor 303, 803 to determine an energy content threshold value to be used for detection of electrical abnormalities during subsequent monitoring of the electrical equipment in a monitoring phase following the calibration process. The energy content threshold value is determined for at least one specific frequency band to be monitored during the monitoring phase, and is determined based on the acoustic signals registered within that specific frequency band during the calibration process. Preferably, the energy content threshold value is set to a value slightly above the energy content of the background noise registered within the frequency band during the calibration process, e.g., slightly above a maximum energy content of any acoustic signal registered within that frequency band during the calibration process.

The at least one processor 303, 803 may further be configured to detect an acoustic pulse among the acoustic signals registered by the sensor device 30 during the monitoring phase, within the monitored frequency band (corresponding to the above mentioned frequency band to be monitored), and to classify the acoustic pulse as an electrical abnormality associated with the electrical equipment when an energy content of the acoustic pulse exceeds the energy content threshold value.

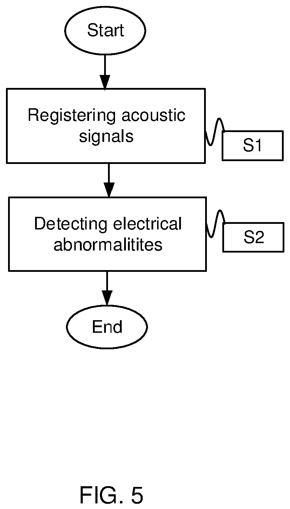

Figure 5 is a flow chart illustrating an exemplary embodiment of a method for detecting electrical abnormalities by means of a system 1 as disclosed for example in figure 4. The method will be described below with simultaneous reference made to previous drawings.

The method comprises the steps of registering S1 acoustic signals reflecting sound from the electrical equipment by means of the sensor device 30; and detecting S2 electrical abnormalities based on the registered acoustic signals.

The step of detecting S2 electrical abnormalities based on the registered acoustic signals may comprise comparing a predetermined characteristic of the acoustic signals with a characteristic threshold value. If the characteristic of an acoustic signal exceeds the characteristic threshold value, it may be concluded that an electrical abnormality has occurred in association with the electrical equipment. The step of detecting S2 electrical abnormalities may thus comprise determining a characteristic threshold value typically corresponding to a characteristic value during normal operation of the electrical equipment. In one example, the characteristic comprises energy content and the threshold value is an energy content threshold value. The step of detecting S2 electrical abnormalities may thus comprise comparing the energy content value of the registered acoustic signals with the energy content threshold value and based on the comparison determine if an electrical abnormality is occurring. If the energy content value of a registered acoustic signal exceeds the energy content threshold value, it indicates that an electrical abnormality is occurring. The acoustic signal may then be classified as an electrical abnormality.

The step of registering S1 acoustic signals may comprise registering, during a calibration process, acoustic signals reflecting sound of the electrical equipment during normal operation thereof.

The step of detecting S2 electrical abnormalities may comprise determining an energy content threshold value for acoustic signals within at least one frequency band to be monitored during monitoring of the electrical equipment following the calibration process, based on the acoustic signals registered within the at least one frequency band during the calibration process. It may also comprise detecting, among acoustic signals registered by the acoustic sensor device 30 during monitoring of the electrical equipment following the calibration process, an acoustic pulse within the at least one frequency band, and classifying the acoustic pulse as an electrical abnormality associated with the electrical equipment when an energy content of the acoustic pulse exceeds the energy content threshold value.

The at least one frequency band may be selected to exclude high-energy content acoustic signals generated by the electrical equipment during normal operation thereof.

The step of detecting S2 electrical abnormalities may comprise comparing energy contents of different frequencies of the acoustic signals registered during the calibration process, and determining the at least one frequency band to be monitored as a frequency band having a relatively low energy content, based on the comparison. Each of the at least one frequency band has a bandwidth of at most 100 Hz, preferably at most 75 Hz, and even more preferably at most 50 Hz.

In some embodiments, the characteristic comprises pulse duration time. The step of detecting S2 electrical abnormalities may then comprise determining a pulse duration time of the acoustic pulse, and classifying the acoustic pulse as an electrical abnormality only when the pulse duration time is below a maximum pulse duration threshold value.

In some embodiments, the characteristic comprises a measure indicative of a rate of increase of energy content and the method may comprise determining a measure indicative of a rate of increase of energy content of the acoustic pulse, and classifying the acoustic pulse as an electrical abnormality only when the measure of the rate of increase exceeds a set threshold value.

In some embodiments, the characteristic comprises a measure indicative of a rate of decrease of energy content and the method may comprise determining a measure indicative of a rate of decrease of energy content of the acoustic pulse, and classifying the acoustic pulse as an electrical abnormality only when the measure of the rate of decrease exceeds a set threshold value.

The method may further comprise generating an alarm signal and/or automatically switching off the electrical equipment in response to classifying the acoustic signal/pulse as an electrical abnormality.

As clear from the foregoing description, the method is typically a computer-implemented method performed by one or more processors 303, 803 of the system 1 upon execution of a computer program. As also clear from the foregoing description, the computer program may be a distributed computer program comprising program components residing in both the sensor device 30 and the network server 80. The method may hence be performed by both the processor 303 of the acoustic sensor 30 and the processor 803 of the network server 80.

The person skilled in the art realizes that the present disclosure is not limited to the embodiments described above. The person skilled in the art further realizes that modifications and variations are possible within the scope of the appended claims. For example, it should be realized that all or some of the functionality described herein as residing in the network node 80 may, in other embodiments, reside in the sensor device 30. In yet other embodiments, all or some of the functionality described herein as residing in the network node 80 may reside in a client device in direct communication with the sensor device 30, such as the electronic device 70A-70C. Consequently, it should be realized that there can be improvements and modifications made of the present invention described in detail above, insofar as they fall within the scope of the invention as set forth in the accompanying claims.

## Claims

1. A sensor device (30) for detection of electrical abnormalities in association with electrical equipment, the sensor device (30) being configured to be arranged on a mounting rail (10) for electrical equipment and comprising:
- a housing (32); and
- an acoustic sensor element (301) arranged inside the housing (32) to register acoustic signals reflecting sound originating from the electrical equipment arranged in association with the mounting rail (10) on which the sensor device (30) is attached, the sound manifesting itself in form of structure-borne sound or vibrations in the mounting rail (10);
wherein the acoustic sensor element (301) is operatively connectable to at least one processor (303, 803) configured to detect the presence of electrical abnormalities based on the acoustic signals registered by the acoustic sensor element (301), wherein the sensor device (30) is configured such that, when arranged on the mounting rail (10), the acoustic sensor element (301) abuts the mounting rail (10).

2. The sensor device (30) according to claim 1, wherein the sensor device (30) comprises an attachment arrangement (40) for detachable attachment on the mounting rail (10).

3. The sensor device (30) according to claim 2, wherein the attachment arrangement (40) comprises a snap-fit connection.

4. The sensor device (30) according to claim 2, wherein the attachment arrangement (40) comprises an adjustable clamping element (400).

5. The sensor device (30) according to any one of the preceding claims, wherein the acoustic sensor element (301) comprises a protrusion (301b) adapted to extend through an aperture (33) in the housing (32) to abut the mounting rail (10).

6. The sensor device (30) according to any one of the preceding claims, wherein the sensor device (30) further comprises a protective sheet (35) arranged adjacent to the acoustic sensor element (301).

7. The sensor device (30) according to any one of the preceding claims, wherein the sensor device (30) further comprises a dampening element (36) arranged in connection with the acoustic sensor element (301).

8. The sensor device (30) according to any one of the preceding claims, wherein the sensor device (30) further comprises a pressure part (37) arranged to apply a pressure on the acoustic sensor element (301).

9. The sensor device (30) according to any one of the preceding claims, wherein the sensor device (30) is configured, such that the acoustic sensor element (301) abuts a flange section (14) of the mounting rail (10).

10. A system (1) for detecting electrical abnormalities in association with electrical equipment, the system (1) comprising a sensor device (30) according to any one of the preceding claims, and at least one processor (303, 803) operatively coupled to the acoustic sensor element (301) of the sensor device (30), wherein the processor (303, 803) is configured to detect occurrence of electrical abnormalities based on the acoustic signals registered by the sensor device (30).

11. A method for detecting electrical abnormalities in association with electrical equipment by means of a system (1) according to claim 10, the method comprising:
i) registering (S1) acoustic signals reflecting sound from the electrical equipment by means of the sensor device (30); and
ii) detecting (S2) electrical abnormalities based on the registered acoustic signals.

12. A computer program comprising computer-readable instructions which, when executed by at least one processor (303, 803) of the system (1) for detecting electrical abnormalities in association with electrical equipment according to claim 10, causes the at least one processor (303, 803) to perform the steps of:
- receiving acoustic signals reflecting sound from the electrical equipment registered by the sensor device (30) of the system (1); and
- detecting electrical abnormalities based on the received acoustic signals.

## Patentansprüche

1. Sensorvorrichtung (30) zur Erkennung von elektrischen Anomalien in Zusammenhang mit einer elektrischen Ausrüstung, wobei die Sensorvorrichtung (30) dazu konfiguriert ist, an einer Montageschiene (10) für eine elektrische Ausrüstung angeordnet zu sein, und Folgendes umfasst:
- ein Gehäuse (32); und
- ein akustisches Sensorelement (301), das innerhalb des Gehäuses (32) angeordnet ist, um akustische Signale zu registrieren, die Ton reflektieren, der von der elektrischen Ausrüstung ausgeht, die in Zusammenhang mit der Montageschiene (10) angeordnet ist, auf der die Sensorvorrichtung (30) angebracht ist, wobei sich der Ton in Form von strukturgetragenem Ton oder Vibrationen in der Montageschiene (10) manifestiert;
wobei das akustische Sensorelement (301) mit zumindest einem Prozessor (303, 803) wirkverbindbar ist, der dazu konfiguriert ist, das Vorhandensein von elektrischen Anomalien basierend auf den akustischen Signalen, die durch das akustische Sensorelement (301) registriert werden, zu erkennen, wobei die Sensorvorrichtung (30) konfiguriert ist, sodass, wenn an der Montageschiene (10) angeordnet, das akustische Sensorelement (301) an der Montageschiene (10) anliegt.

2. Sensorvorrichtung (30) nach Anspruch 1, wobei die Sensorvorrichtung (30) eine Anbringungsanordnung (40) zur lösbaren Anbringung an der Montageschiene (10) umfasst.

3. Sensorvorrichtung (30) nach Anspruch 2, wobei die Anbringungsanordnung (40) eine Schnappverbindung umfasst.

4. Sensorvorrichtung (30) nach Anspruch 2, wobei die Anbringungsanordnung (40) ein einstellbares Klemmelement (400) umfasst.

5. Sensorvorrichtung (30) nach einem der vorhergehenden Ansprüche, wobei das akustische Sensorelement (301) einen Vorsprung (301b) umfasst, der dazu ausgelegt ist, sich durch eine Öffnung (33) in dem Gehäuse (32) zu erstrecken, um an der Montageschiene (10) anzuliegen.

6. Sensorvorrichtung (30) nach einem der vorhergehenden Ansprüche, wobei die Sensorvorrichtung (30) ferner eine Schutzfolie (35) umfasst, die benachbart zu dem akustischen Sensorelement (301) angeordnet ist.

7. Sensorvorrichtung (30) nach einem der vorhergehenden Ansprüche, wobei die Sensorvorrichtung (30) ferner ein Dämpfungselement (36) umfasst, das in Verbindung mit dem akustischen Sensorelement (301) angeordnet ist.

8. Sensorvorrichtung (30) nach einem der vorhergehenden Ansprüche, wobei die Sensorvorrichtung (30) ferner ein Druckteil (37) umfasst, das dazu angeordnet ist, einen Druck auf das akustische Sensorelement (301) auszuüben.

9. Sensorvorrichtung (30) nach einem der vorhergehenden Ansprüche, wobei die Sensorvorrichtung (30) konfiguriert ist, sodass das akustische Sensorelement (301) an einem Flanschabschnitt (14) der Montageschiene (10) anliegt.

10. System (1) zum Erkennen von elektrischen Anomalien in Zusammenhang mit einer elektrischen Ausrüstung, wobei das System (1) eine Sensorvorrichtung (30) nach einem der vorhergehenden Ansprüche und zumindest einen Prozessor (303, 803), der an das akustische Sensorelement (301) der Sensorvorrichtung (30) wirkgekoppelt ist, umfasst, wobei der Prozessor (303, 803) dazu konfiguriert ist, Auftreten von elektrischen Anomalien basierend auf den akustischen Signalen, die durch die Sensorvorrichtung (30) registriert werden, zu erkennen.

11. Verfahren zum Erkennen von elektrischen Anomalien in Zusammenhang mit einer elektrischen Ausrüstung mittels eines Systems (1) nach Anspruch 10, wobei das Verfahren Folgendes umfasst:
i) Registrieren (S1) von akustischen Signalen, die Ton von der elektrischen Ausrüstung reflektieren, mittels der Sensorvorrichtung (30); und
ii) Erkennen (S2) von elektrischen Anomalien basierend auf den registrierten akustischen Signalen.

12. Computerprogramm, umfassend computerlesbare Anweisungen, die, wenn durch zumindest einen Prozessor (303, 803) des Systems (1) zum Erkennen von elektrischen Anomalien in Zusammenhang mit einer elektrischen Ausrüstung nach Anspruch 10 ausgeführt, den zumindest einen Prozessor (303, 803) dazu veranlassen, die folgenden Schritte durchzuführen:
- Empfangen von akustischen Signalen, die Ton von der elektrischen Ausrüstung reflektieren, die durch die Sensorvorrichtung (30) des Systems (1) registriert werden; und
- Erkennen von elektrischen Anomalien basierend auf den empfangenen akustischen Signalen.

## Revendications

1. Dispositif capteur (30) pour la détection d'anomalies électriques en association avec un équipement électrique, le dispositif capteur (30) étant configuré pour être agencé sur un rail de montage (10) pour équipement électrique et comprenant :
- un boîtier (32) ; et
- un élément capteur acoustique (301) agencé à l'intérieur du boîtier (32) pour enregistrer des signaux acoustiques traduisant un son provenant de l'équipement électrique agencé en association avec le rail de montage (10) sur lequel le dispositif capteur (30) est fixé, le son se manifestant sous forme de bruit solide ou de vibrations dans le rail de montage (10) ;
dans lequel l'élément capteur acoustique (301) peut être relié de manière opérationnelle à au moins un processeur (303, 803) configuré pour détecter la présence d'anomalies électriques sur la base des signaux acoustiques enregistrés par l'élément capteur acoustique (301), dans lequel le dispositif capteur (30) est configuré de sorte que, lorsqu'il est agencé sur le rail de montage (10), l'élément capteur acoustique (301) vient en butée contre le rail de montage (10).

2. Dispositif capteur (30) selon la revendication 1, dans lequel le dispositif capteur (30) comprend un agencement de fixation (40) pour une fixation amovible sur le rail de montage (10).

3. Dispositif capteur (30) selon la revendication 2, dans lequel l'agencement de fixation (40) comprend un raccordement par encliquetage.

4. Dispositif capteur (30) selon la revendication 2, dans lequel l'agencement de fixation (40) comprend un élément de serrage réglable (400).

5. Dispositif capteur (30) selon l'une quelconque des revendications précédentes, dans lequel l'élément capteur acoustique (301) comprend une saillie (301b) adaptée pour s'étendre à travers une ouverture (33) dans le boîtier (32) pour venir en butée contre le rail de montage (10).

6. Dispositif capteur (30) selon l'une quelconque des revendications précédentes, dans lequel le dispositif capteur (30) comprend en outre une feuille de protection (35) agencée de manière adjacente à l'élément capteur acoustique (301).

7. Dispositif capteur (30) selon l'une quelconque des revendications précédentes, dans lequel le dispositif capteur (30) comprend en outre un élément d'amortissement (36) agencé en liaison avec l'élément capteur acoustique (301).

8. Dispositif capteur (30) selon l'une quelconque des revendications précédentes, dans lequel le dispositif capteur (30) comprend en outre une pièce de pression (37) agencée pour appliquer une pression sur l'élément capteur acoustique (301).

9. Dispositif capteur (30) selon l'une quelconque des revendications précédentes, dans lequel le dispositif capteur (30) est configuré de sorte que l'élément capteur acoustique (301) vient en butée contre une section de rebord (14) du rail de montage (10).

10. Système (1) pour la détection d'anomalies électriques en association avec un équipement électrique, le système (1) comprenant un dispositif capteur (30) selon l'une quelconque des revendications précédentes, et au moins un processeur (303, 803) couplé de manière opérationnelle à l'élément capteur acoustique (301) du dispositif capteur (30), dans lequel le processeur (303, 803) est configuré pour détecter la survenance d'anomalies électriques sur la base des signaux acoustiques enregistrés par le dispositif capteur (30).

11. Procédé pour la détection d'anomalies électriques en association avec un équipement électrique au moyen d'un système (1) selon la revendication 10, le procédé comprenant :
i) l'enregistrement (S1) de signaux acoustiques traduisant un son provenant de l'équipement électrique au moyen du dispositif capteur (30) ; et
ii) la détection (S2) d'anomalies électriques sur la base des signaux acoustiques enregistrés.

12. Programme informatique comprenant des instructions lisibles par ordinateur qui, lorsqu'elles sont exécutées par au moins un processeur (303, 803) du système (1) pour la détection d'anomalies électriques en association avec un équipement électrique selon la revendication 10, amènent l'au moins un processeur (303, 803) à réaliser les étapes consistant à :
- recevoir des signaux acoustiques traduisant un son provenant de l'équipement électrique enregistrés par le dispositif capteur (30) du système (1) ; et
- détecter des anomalies électriques sur la base des signaux acoustiques reçus.
